# EUROPEAN PATENT APPLICATION

(11) **EP 4 394 852 A1**
(43) Date of publication of application: **03.07.2024**
(21) Application number: 22217348.6
(22) Date of filing: 30.12.2022
(51) Int. Cl.: H01L 21/67, H01L 23/00, B25J 7/00, B25J 9/00

(54) **PICK AND PLACE WITH DIE ACTUATORS FOR HETEROGENEOUS INTEGRATION**

(71) Applicant: ASML Netherlands B.V., 5500 AH Veldhoven (NL)
(72) Inventor: DE JAGER, Pieter, Willem, Herman, 5500 AH Veldhoven (NL); VAN ZWET, Erwin, John, 5500 AH Veldhoven (NL); VAN RIEL, Martinus, Cornelius, Johannes, Maria, 5500 AH Veldhoven (NL); VAN DER LANS, Marcus, Johannes, 5500 AH Veldhoven (NL); DE MAN, Hendrik, 5500 AH Veldhoven (NL)
(74) Representative: ASML Netherlands B.V.

(57) **Abstract**

A method for die placement is provided, comprising obtaining a plurality of target locations for a plurality of donor dies, measuring locations of the plurality of donor dies, the plurality of donor dies supported by a plurality of die actuators, adjusting the locations of the plurality of donors dies to correspond substantially to the plurality of target locations using the plurality of die actuators, and placing the plurality of donor dies on the plurality of target locations

## Description

### TECHNICAL FIELD

The present disclosure relates generally to a system and method for heterogeneous integration.

### BACKGROUND

In manufacturing processes of integrated circuits (ICs), multiple finished or unfinished ICs (e.g., whole wafers, diced wafers, partially diced wafers, chips, die, etc.) may be placed in contact, stacked, bonded, or otherwise joined (e.g., to heterogeneous or homogeneous devices) at various points in the fabrication process. Heterogeneous integration, e.g., the integration of different circuits or other patterned devices, may rely upon joining of specific portions (for example, conductive contact elements) of multiple die-where these specific portions which may be aligned in three-dimensional space to ensure functional connectivity. Alignment of these die, which may have multiple fabrication layers, different critical dimensions, different nodes, packaging, etc., with each other may require different techniques then use for lithography during fabrication. As the physical sizes of IC components continue to shrink, and their structures continue to become more complex, accuracy and throughput in integration become more important. For applications such as heterogeneous integration, it may be desirable to obtain both accurate and fast placement of die with respect to one another

In the context of semiconductor manufacture, improvements in die placement and alignment (e.g., improvements in heterogeneous integration) lead to improvements in IC manufacturing and integration abilities.

### SUMMARY

According to an embodiment, there is provided a method for die placement comprising obtaining a plurality of target locations for a plurality of donor dies, measuring locations of the plurality of donor dies, where the plurality of donor dies are supported by a plurality of die actuators, adjusting the locations of the plurality of donors dies to correspond substantially to the plurality of target locations using the plurality of die actuators, and placing the plurality of donor dies on the plurality of target locations.

In an embodiment, measuring the locations of the plurality of donor dies comprises placing the plurality of donor dies onto the plurality of die actuators, where the plurality of die actuators are supported by a support structure, and measuring the locations of the plurality of donor dies with respect to the support structure.

In an embodiment, measuring the locations of the plurality of donor dies further comprises placing the plurality of die actuators on the support structure based on the plurality of target locations for the plurality of donor dies.

In an embodiment, adjusting the locations of the plurality of donor dies using the plurality of die actuators comprises adjusting positions of the plurality of donor dies supported by donor die chucks of the plurality of die actuators by actuation of adjustable supports supporting the donor die chucks.

In an embodiment, placing the plurality of donor dies on the plurality of target locations further comprises disengaging the plurality of donor dies from the plurality of die actuators, and bonding the plurality of donor dies to the plurality of target locations.

According to another embodiment, there is provided a die actuator comprising a donor die chuck, and at least three adjustable supports supporting the donor die chuck, where a position of the donor die chuck is controllable by actuation of the adjustable supports.

According to an embodiment, there is provided a support structure comprising a plurality of die actuations.

According to another embodiment, there is provided an apparatus comprising a plurality of die actuators, wherein die actuators comprise donor die chucks, each for supporting an associated donor die. A position of each donor die chuck is controllable by actuation thereof. The apparatus includes a measurement system, functionally coupled to the plurality of die actuators, and configured to obtain a plurality of target locations for a plurality of donor dies, obtain locations of the plurality of donor dies supported by the donor die chucks, and adjust the locations of the plurality of donor dies by actuation of the donor die chucks so that the locations of the plurality of donor dies correspond substantially to the plurality of target locations.

In an embodiment, the die actuators further comprise at least three adjustable supports supporting each donor die chuck, where the position of each donor die chuck is controllable by actuation of the supporting adjustable supports.

In an embodiment, the measurement system comprises a processor configured to adjust the locations of the plurality of donor dies by actuation of the supporting adjustable supports so that the locations of the plurality of donor dies correspond substantially to the plurality of target locations.

According to another embodiment, one or more non-transitory, machine-readable medium is provided having instructions thereon, the instructions when executed by a processor being configured to perform the method of any other embodiment.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:
Figures 1A-1D are a schematic diagram illustrating an exemplary die bonding method, according to an embodiment.
Figures 2A-2B are a schematic diagram illustrating a method of placement of die actuators, according to an embodiment.
Figures 3A-3B are a schematic diagram illustrating a method of placement of donor dies on die actuators, according to an embodiment.
Figures 4A-4B are a schematic diagram illustrating a method of obtaining a plurality of target locations, according to an embodiment.
Figures 5A-5B are a schematic diagram illustrating a method of adjusting locations of donor dies, according to an embodiment.
Figures 6A-6D are schematic diagrams illustrating steps of a method of placing a donor dies on target locations, according to an embodiment.
Figure 7 is a flowchart which illustrates a method of die alignment, according to an embodiment.
Figures 8A-8B are schematic diagrams illustrating an example die actuator, according to an embodiment.
Figure 9 is a schematic diagram illustrating a relationship between an example pick and place system and an example die actuator, according to an embodiment.
Figures 10A-10B are schematic diagrams illustrating an example die actuator, according to an embodiment.
Figure 11 is a flowchart which illustrates a method of die actuator adjustment, according to an embodiment.
Figure 12 is a block diagram of an example computer system, according to an embodiment of the present disclosure.

### DETAILED DESCRIPTION

Embodiments of the present disclosure are described in detail with reference to the drawings, which are provided as illustrative examples of the disclosure so as to enable those skilled in the art to practice the disclosure. Notably, the figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure. Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "wafer" or "die" in this text should be considered as interchangeable with the more general terms "substrate" and "target portion", respectively. The term "wafer" may be used generally to refer to a large unit of manufacture (which may be the largest unit of manufacture), while the term "die" may be used to refer to a smaller unit of manufacture which may correspond to a lithography pattern, a portion of a lithography pattern, multiple lithography patterns, etc. A "die" may correspond to a portion of "wafer"-that is a "die" may be produced by dicing or otherwise dividing a "wafer". The term "die" should be considered as interchangeable with the term chip, chiplet, or other terms for IC divisions. A patterning device (for example, a lithography device) can comprise, or can form, one or more patterns, which may correspond to one or more die. The patterns can be generated utilizing CAD (computer-aided design) programs, based on a pattern or design layout, this process often being referred to as EDA (electronic design automation).

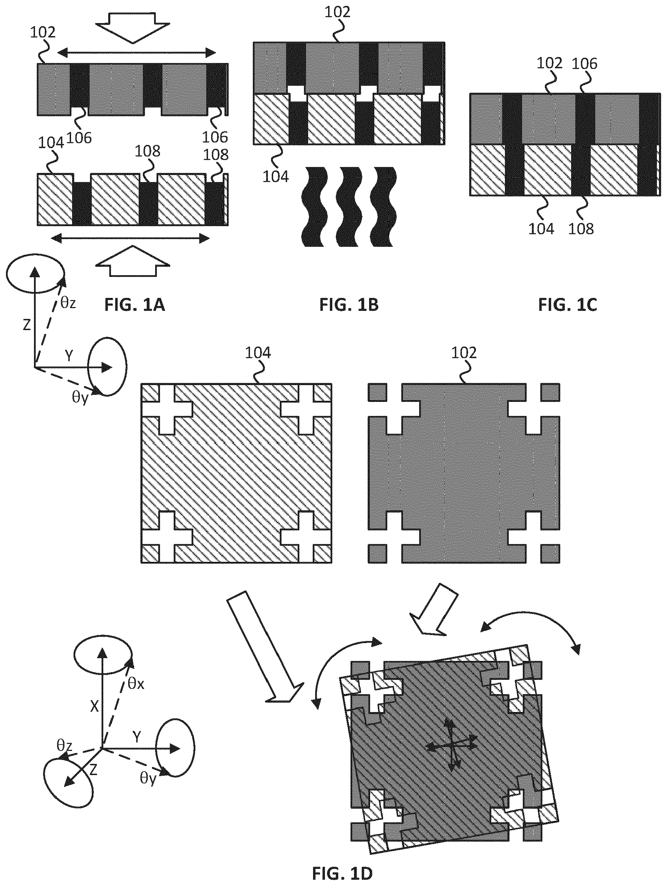

Reference is now made to Figures 1A-1D, which are a schematic diagram illustrating an exemplary die bonding method consistent with embodiments of the present disclosure. The exemplary die bonding method is depicted in relation to a reference set of axes. The reference axes are provided for ease of description only and are not to be taken as limiting. Included methods and apparatuses can instead be described with reference to a different set of axes (e.g., cylindrical coordinates, polar coordinates, etc.), a different origin point (e.g., an origin point in the donor die, an origin point in the target, origin point in between the donor die and target, etc.), or a different orientation. The standard set of axes is chosen such that the fabrication plane of the die (i.e., a wafer surface) lies in the x-y plane and where the fabrication direction is parallel or antiparallel to the z-axis for both the donor die and target locations.

As shown in Figures 1A-1D, the exemplary die bonding method may involve a donor die 102 and a target die 104. Herein, the term "donor" and the term "target" are used for ease of description. It should be understood that the term "donor" and the term "donor" are provided for reference and are relative and that elements described as corresponding to a "donor" can instead correspond to a "target" and vice versa. The donor die 102 may have electrically active areas 106. The electrically active areas 106 may correspond to vias (e.g., through silicon vias (TSVs)), electrical contact lines, contact pads, packaging pads, or other electrically conductive areas. The donor die 102 may have one or more electrically inert areas (for example, electrically insulating areas) outside of the electrically active areas 106. The electrically active areas 106 may be recessed (as shown) with respect to other surfaces of the donor die 102. The electrically active areas 106 may correspond to contacts (e.g., to source, to drain, to gate, etc.) to electrical devices within the donor die 102 (not shown). The target die 104, likewise, may have electrically active areas 108, which may have similar properties to the electrically active areas 106.

As shown in Figure 1A, the exemplary die bonding method may involve alignment of at least some of the electrically active areas 106 of the donor die 102 with at least some of the electrically active areas 108 of the target die 104. The exemplary die bonding method may involve bringing the donor die 102 into contact with the target die 104 while maintaining alignment between the electrically active areas 106 in the electrically active areas 108. The alignment may be complicated by the multiple layers of the donor die 102 or the multiple layers of the target die 104, which may be optically opaque. Figures 1A-1C depict a cross-sectional view of portions of the exemplary die bonding method.

As further shown in Figure 1A, the donor die 102 and the target die 104 may be brought together along the z-axis, while the position of the donor die 102 or the target die 104 may be adjusted in the x-y plane (e.g., perpendicular to the z-axis of approach). As shown in Figure 1B, the donor die 102 and the target die 104 may be annealed after contact. Annealing may be or include heat annealing, electrical annealing, electrostatic processes, van der Waals processes, etc. As shown in Figure 1C, annealing may cause physical or chemical changes in the electrically active areas 106 of the donor die 102 or in the electrically active areas 108 of the target die 104 which may cause physical contact or electrical contact between the electrically active areas 106 in the electrically active areas 108. Annealing may therefore produce electrical connectivity between elements of the donor die 102 and the target die 104 (e.g., integration). This electrical connectivity may occur even if the electrically active areas 106 and the electrically active areas 108 differ-for example, have different recessed depths, are made up of different materials, have different dimensions, etc.

Figure 1D depicts a plan view of an example die bonding method according to this disclosure. As shown in Figure 1D, the donor die 102 and the target die 104 may have alignment marks along the x-y plane to facilitate alignment of the die as a whole. Alignment marks in the x-y plane of die (e.g., the donor die 102 or the target die 104) may reduce the area available for circuitry. Lithography alignment marks used during fabrication of wafers may be placed in waste areas, such as areas between chips, which may then destroyed by dicing. Dicing herein refers to mechanical separation of areas of a wafer (e.g., a unit of manufacture) into smaller areas (e.g., dies or chips) which may contain one or more units of operation (e.g., a logic device, a memory unit, etc.). Dicing may operate using any appropriate method-for example, scribing and breaking, mechanical sawing, laser cutting, etc.and may destroy (e.g., grind to powder or otherwise render inoperable for circuitry placement) a nonzero linewidth portion of the wafer volume when separating die. Alternatively, the electrically active areas 106 of the donor die 102 or the electrically active areas 108 of the target die 104 (not shown in Figure 1D) or other surface features may function as reference marks for alignment (e.g., alignment marks) of the donor die 102 and the target die 104. The donor die 102 and the target die 104 may be aligned in three dimensions before or during contact between the donor die 102 and the target die 104. For example, the donor die 102 or the target die 104 may be positioned or adjusted in the x-y plane as the donor die 102 and the target die 104 are contacted. The donor die 102 or the target die 104 may be positioned or adjusted by operation of a die actuator or other die-scale elements, such as by piezoelectric stepper elements, or by operation of a wafer chuck or other wafer-scale elements, such as by stepper elements.

The position of the donor die 102 or the target die 104 may be adjusted with respect to up to six degrees of freedom. For example, given an origin point at the center of the donor die 102, the donor die 102 may be adjusted by movement along the X axis (e.g., in a positive or negative X direction), along the y-axis (e.g. in a positive or negative Y direction), along the z-axis (e.g., in a positive or negative Z direction). The donor die 102 may also be adjusted rotationally with respect to each of those axes-e.g., rotated with respect to the x-axis, rotated with respect to the y-axis, rotated with respect to the z-axis. That is, the donor die 102 may be adjusted by free rotation in space accounted for by six different types of movement (where the movements listed above are provided as examples but where the movements may be described by other axes).

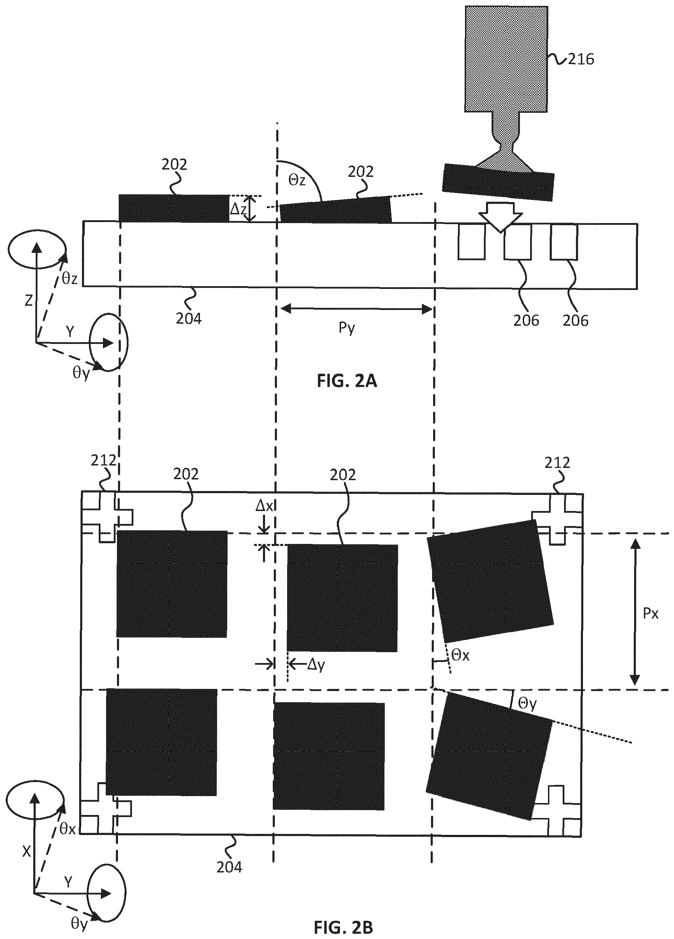

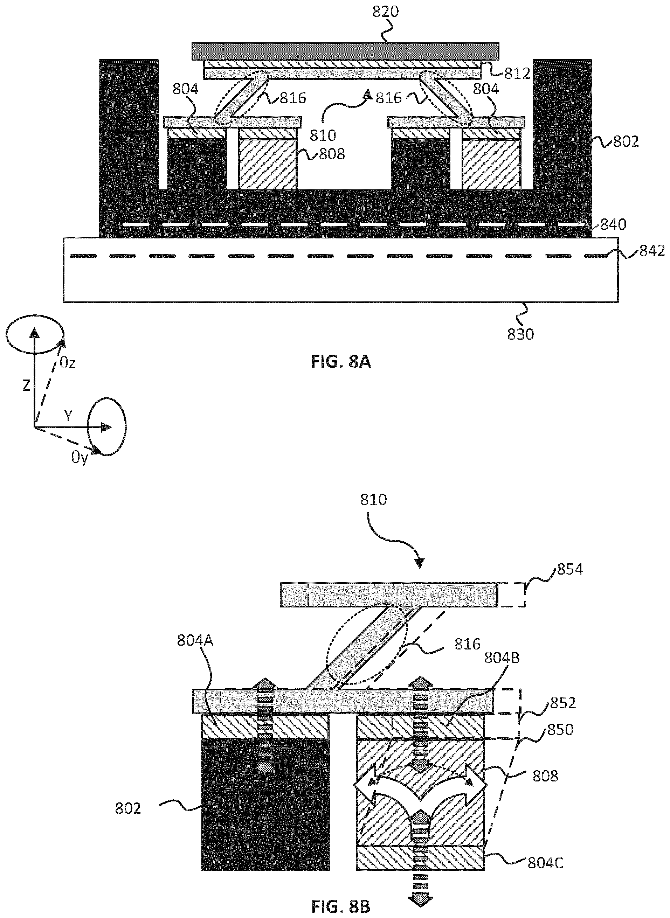

Figures 2A-2B are a schematic diagram illustrating a method of placement of die actuators. Figure 2A depicts a cross-sectional view of placement of die actuators 202 on the support structure 204. The die actuators 202 may be devices capable of supporting one or more donor die (e.g. donor die 102 of Figures 1A-1D). The die actuators 202 may support donor die on one or more donor die chuck or other support structure. The die actuators 202 may electrostatically or otherwise secure the donor die to the one or more die chuck or other support structure. The die actuators 202 may have one or more adjustable element (e.g., strut) which may be activated to adjust a position of the donor die. The die actuators 202 may be able to adjust the position of the donor die and up to six directions (e.g., with respect to six degrees of freedom). The die actuators 202 may be placed on the support structure 204 by a pick and place element 216. The pick and place element 216 may place the die actuators 202 on the support structure 204 at given positions. The pick and place element 216 may be a chip shooter, gravity-based placer, a suction (e.g., vacuum) or other hydraulic based placer, etc. The pick and place element 216 may have an end effector or other element which makes contact with a die actuator. The end effector may include an adhesion element (for example, an electrostatic clamp, suction element), which allows the end effector to pick up and/or release a die actuator. The end effector may also include an adjustable or configurable clamping element (such as a grabber arm or the like) for grabbing die actuators, such as those which may not have flat surfaces suitable for suction adhesion. The given positions may be regular, that is occur with periodicity (for example, periodicity P_{Y} in the Y direction and periodicity P_{X} in the X direction). The pick and place element 216 may also place the die actuators 202 on the support structure 204 with a given position in the Z direction (e.g., Δz). The pick and place element 216 may have intrinsic error or inaccuracy on the order of the size of the die actuator, the periodicity of placement, the alignment features of the die actuator, etc. The die actuators 202, therefore, may have irregular placement and or inaccuracies with respect to desired positions. The die actuators 202 will also be further discussed in reference to Figures 8-10.

The support structure 204 may be planar, such as a wafer, and may be considered a reconstructed wafer chuck since it may be used to reconstruct the wafer from which the donor die were diced. The support structure 204 may be a planar structure other than a wafer or may otherwise correspond to an arrangement of target die (not shown in Figure 2A-2B). The support structure 204 may be nonplanar. For example the support structure 204 may have one or more recesses or elevated areas corresponding to the die actuators 202. The support structure 204 may have one or more alignment marks 206. The alignment marks 206, corresponding to a grating, are example alignment marks only in the alignment marks may instead have different or additional features. The alignment marks 206 may occur in areas not occupied by the die actuators 202. The alignment marks 206 may be detectable, optically or otherwise (such as via UV light, via X-ray detection, via physical interlocking elements, etc.), from the top or bottom of the support structure 204. For example, the support structure 204 may be optically transparent such that the alignment marks 206 may be viewed from either a positive or negative Z direction.

Figure 2B depicts a plan view of the die actuators 202 placed on the support structure 204. The positions of the die actuators 202 may be described with reference to one or more origin point. For ease of description, the positions of the die actuators 202 are here in described with reference to their intended position (e.g., as given by periodicity Px and periodicity P_{Y} and Δz). The position of each of the die actuators 202 may be described in free space by six coordinates -Δx and Θx and along the x-axis, Δy and Oy along the y-axis, and Δz and Oz along the z-axis (as shown in Figure 2A). The angle Θi (where i is any one of x, y, or z) corresponds to the angle of rotation of the donor die about the corresponding axis. Because there may be out of plane rotation (e.g., along Oz), the angles Oz and Oy may not be complementary. The positions of the die actuators 202 may be limited by the accuracy and reproducibility of the pick and place element 216 and by the regularity of the support structure 204. In Figure 2B, alternate alignment marks 212 are shown.

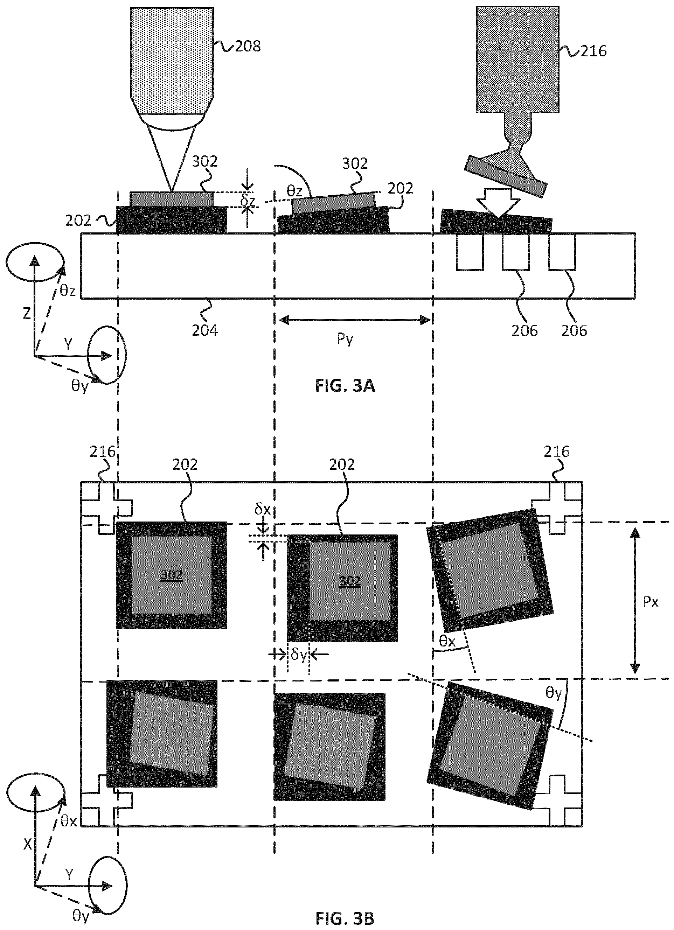

Figures 3A-3B are a schematic diagram illustrating a method of placement of donor dies on die actuators. Figure 3A depicts a cross-sectional view of placement of donor dies 302 on the die actuators 202 on the support structure 204. The donor dies 302 may be any dies suitable for heterogeneous integration (or homogeneous integration). The donor dies 302 may be supported by the die actuators 202. The donor dies 302 may be placed on the die actuators 202 by the pick and place element 216, or alternatively by another pick and place element or another method (for example, by using a chip shooter). In one embodiment, the donor dies 302 may be attached to elements of the die actuators 202 before dicing of a wafer containing the donor dies 302, such as through backside adhesion. After dicing, the donor dies 302 attached to the die actuators 202 may be placed on the support structure 204. The donor dies 302 may be donor dies from a single wafer, for multiple wafers of the same type, or from different types of wafers. In one embodiment, the donor dies 302 may have substantially the same dimensions. The donor dies 302 may each be supported by one of the die actuators 202. In some embodiments, multiple of the donor dies 302 may each be supported by one of the die actuators 202. In some embodiments, some of the die actuators 202 may be empty or otherwise not correspond to one of the donor dies 302. The donor dies 302 may be larger or smaller in dimension than the die actuators 202. The donor dies 302 may be electrostatically or otherwise secured to the die actuators 202.

The pick and place element 216 may place the donor dies 302 on the die actuators 202 at given positions. The given positions may be the same or different for each of the die actuators 202. For example, the pick and place element 216 may attempt to place the donor dies 302 on the die actuators 202 relative to the given positions (e.g., as given by periodicity P_{Y} in the Y direction and periodicity Px in the X direction) with respect to the support structure 204. In another example, the pick and place element 216 may attempt to place the donor dies 302 on the die actuators 202 with respect to only the position of the die actuators 202. The pick and place element 216 may or may not attempt to compensate for irregularities in the placement of the die actuators 202 when placing the donor die 302.

A location measurement device 208 is also shown in FIG. 3A. The location measurement device 208 may be a camera, e.g., a two-dimensional camera, two or more one-dimensional cameras, an optical camera, etc., or another measurement device. The location measurement device 208 may be made up of multiple location measurement devices, such as an in-plane measurement device which may measure locations in the x-y plane and an out of plane measurement device which may measure locations or distances in the Z direction. In one embodiment, the location measurement device 208 comprises a confocal microscope, which measures depth. The confocal microscope may measure depth (e.g., position in the Z direction) based on detection of depth of a focal plane when focusing on an element or surface. The confocal microscope may measure depth relative to other positions on the die-for example, may detect changes in depth in the Z direction across the die surface-or may measure absolute depth-for example, distance of the die surface from the microscope. In one embodiment, the location measurement device 208 may measure position, relative or absolute position, using overlay diffraction or other diffraction-based methods, such as based on scattering by gratings within or on the die. In one embodiment, positions of the die may be determined based on two-dimensional images of the die. For example, a x offset, a y-offset, an angle of rotation with respect to the x-axis, or an angle of rotation with respect to the y-axis may be determined based on detection of edges or sides of the die, where the offsets may be determined relative to a die actuator, a position on the support structure 204, etc. In one embodiment, positions of the die may be determined based on one-dimensional images of the die, such as acquired by an in-line camera. For example, a x offset, a y-offset, an angle of rotation with respect to the x-axis, or an angle of rotation with respect to the y-axis may be determined based on a one-dimensional (or quasi-one-dimensional image) acquired at known positions. A difference between an intended position and an actual position may be determined based on a difference between an intended position in the one-dimensional image and the actual position in the one-dimensional image. The location measurement device 208 may operate in a scanning mode or from a fixed position relative to the support structure 204.

Figure 3B depicts a plan view of the donor die 302 placed on the die actuators 202 placed on the support structure 204. The positions of the donor die 302 may be described with reference to one or more origin point. For ease of description, the positions of the donor die 302 are here in described with reference to their intended position (e.g., as given by periodicity P_{X} and periodicity P_{Y} and Δz from Figures 2A-2B). The position of each of the donor die 302 may be described in free space by six coordinates -Δx+δx and Θx and along the x-axis, Δy+δy and θy along the y-axis, and Δz+δz and θz along the z-axis (as shown in Figure 3A). The angle θi (where i may be any one of x, y, or z) corresponds to the angle of rotation of the donor die 302 about the corresponding axis. Because there may be out of plane rotation (e.g., along θz as shown in Figure 3A), the angles θz and θy may not be complementary. The positions of the donor die 302 may be limited by the accuracy and reproducibility of the pick and place element 216, the placement of the die actuators 202, and by the regularity of the support structure 204.

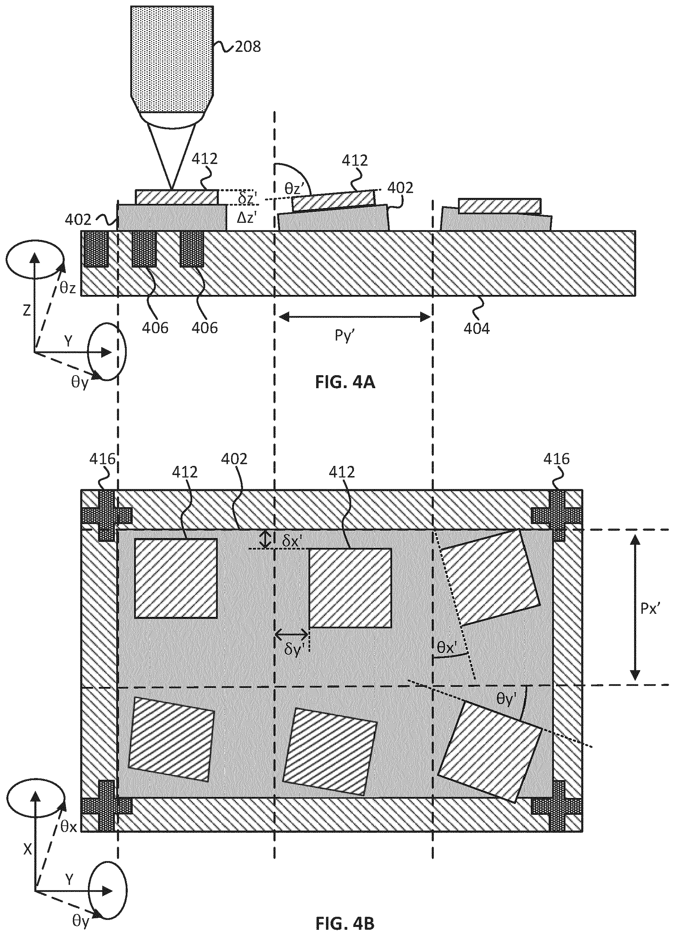

Figures 4A-4B are a schematic diagram illustrating a method of obtaining a plurality of target locations. Figure 4A depicts a cross-sectional view of target die 412 on die actuators 402 on support structure 404. The target die 412 are depicted as individual die, however the target die 412 may instead be one or more contiguous die. For example, the target die 412 may be target die of an undiced wafer, including a completely or relatively un-patterned wafer. The target die 412 may be supported by one or more die actuators 402, or may be placed directly on the support structure 404. The target die 412, like the donor die 302 of Figure 3A-3B, maybe the same or different. The target die 412 may be the same as the donor die 302, or may be different including corresponding to different types of circuitry, different nodes, memory versus logic, etc. The die actuators 402 may have one or more feature as previously described in reference to the die actuators 202. The support structure 404 may have one or more feature as previously described in reference to the support structure 204.

The die actuators 402 may be placed on the support structure 404 by a pick and place element, such as similar to the pick and place element 216. The target die 412 may be placed on the support structure 404 or the die actuators 402 by the pick and place element, such as the pick and place element 216. Intended positions (e.g., of the target die 412 or the die actuators 402) may be regular, that is occur with the periodicity (e.g., periodicity P_{Y}' in the Y direction and periodicity P_{X}' in the X direction). The pick and place element 216 may also place the target die 412 or die actuators 402 on the support structure 404 with a given position in the Z direction (e.g., Δz' or Δz'+ δz'). Intended positions may vary from actual positions due to inaccuracy and reproducibility issues with the pick and place element. The pick and place element may operate in connection with (for example, iteratively) with a location measurement device, such as the location measurement device 208. The location measurement device 208 may be the same as or different from the location measurement device 208 of Figure 3A.

The support structure 404 may be planar, such as a wafer. The support structure 404 may be shaped in a manner to be complementary to the support structure 204 (e.g., of Figure 2A) or vice versa. The support structure 404 may have one or more alignment marks 406. The alignment marks 406, corresponding to a grating, are example alignment marks only. The alignment marks 406 may complement the alignment marks 206 (of Figure 2A). The alignment marks 406 may allow for alignment of the support structure 404 and the support structure 204 (of Figure 2A).

Figure 4B depicts a plan view of the target dies 412 places on the die actuators 402 placed on the support structure 404. As an additional example, the die actuators 402 of Figure 4B are depicted as corresponding to a planar die actuator 402, instead of individual die actuators 402 per target die 412 as shown in Figure 4A. A planar die actuator 402 may be used, for example, if the target die 412 are of a known thickness (e.g., planarized) and may only require position adjustment in plane. The positions of the target die 412 may be described with reference to one or more origin point. For ease of description, the positions of the target die 412 are here in described with reference to their intended position (e.g., as given by periodicity Px and periodicity P_{Y} and Δz). The position of each of the target die 412 may be described in free space by six coordinates -δx' and θx' and along the x-axis, δy' and θy' along the y-axis, and Δz'+δz' and θz' along the z-axis (as shown in Figure 4A). The angle θi corresponds to the angle of rotation of the target die 412 about the corresponding axis. Because there may be out of plane rotation (e.g., along θz), the angles θz and θy may not be complementary. The positions of the target die 412 may be limited by the accuracy and reproducibility of the pick and place element 216, the placement of the die actuators 402, and by the regularity of the support structure 404. The positions of the target die 412 may be more accurate for whole wafers than for diced wafers. In Figure 4B, alternate alignment marks 416 are shown which complement the alternate alignment marks 212 shown in Figure 2B.

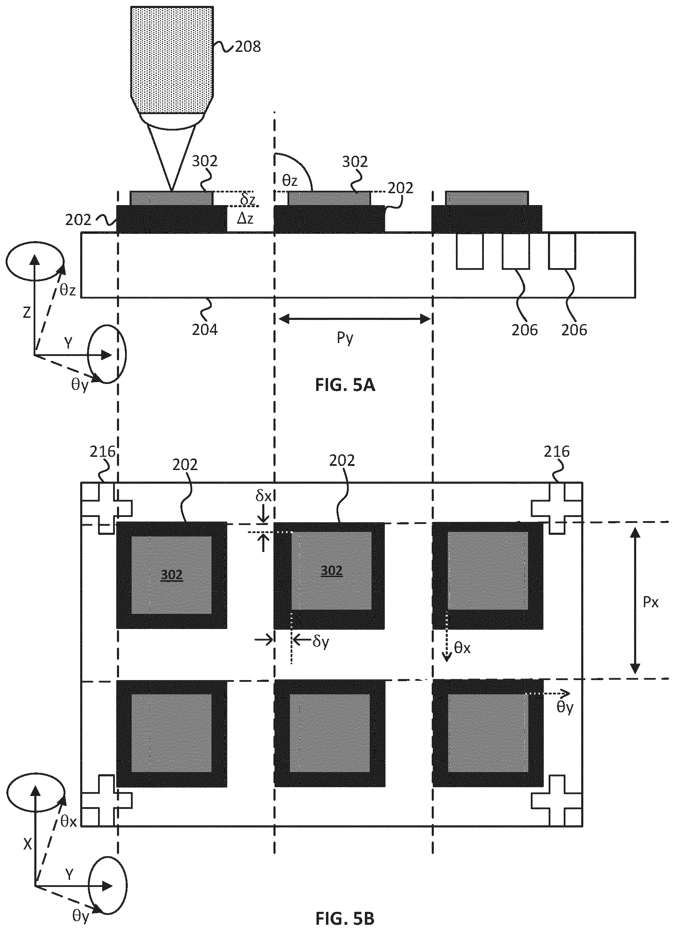

Figures 5A-5B are a schematic diagram illustrating a method of adjusting locations of donor dies. Figure 5A depicts a cross-sectional view of placement of donor dies 302 on the die actuators 202 on the support structure 204 after adjustment of the locations of the donor dies 302. The donor dies 302 may be adjusted (e.g., in position) by any appropriate action of the die actuators 202. Example actions of the die actuators will be further discussed in reference to Figures 8-10.

The die actuators 202 may operate in conjunction with the location measurement device 208. The die actuators 202 may incrementally (or iteratively) adjust positions of the donor die 302 based on or in response to position information acquired by the location measurement device 208. The die actuators 202 may also or instead adjust positions of the donor die 302 based on position information of target die (e.g., the target die 412 of Figure 4A-4B). The die actuators 202 may attempt to move the donor die 302 to intended positions (e.g., to compensate for errors in placement of the die actuators 202). In some embodiments, the die actuators 202 may operate in conjunction with die actuators of target die (e.g., the die actuators 402 of the target die 412 of Figure 4A-4B) to align the donor die 302 with target die at locations which may not be the intended positions. The die actuators 202 may align the donor die 302 with or without respect to positions on the support structure 204 (e.g., such as with or without reference to the alignment marks 206). The die actuators 202 may additionally or instead adjust positions of the die actuators 202 themselves in one or more direction.

Figure 4B depicts a plan view of the donor die 302 placed on the die actuators 202 placed on the support structure 204 after alignment. The positions of the donor die 302 may be described with reference to one or more origin point. The position of each of the donor die 302 may be described in free space by six coordinates -δx and θx along the x-axis (where θx indicates parallelism with the x-axis), δy and θy along the y-axis (where θy indicates parallelism with the y-axis), and Δz+δz and θz along the z-axis (as shown in Figure 4A) where θz indicates parallelism between the x-y longitudinal planes of the donor die 302 and the support structure 204. The positions of the donor die 302 may be limited by the accuracy and reproducibility of die actuators 202 and may still include placement errors, which may be smaller than placement errors possible when using a pick and place element.

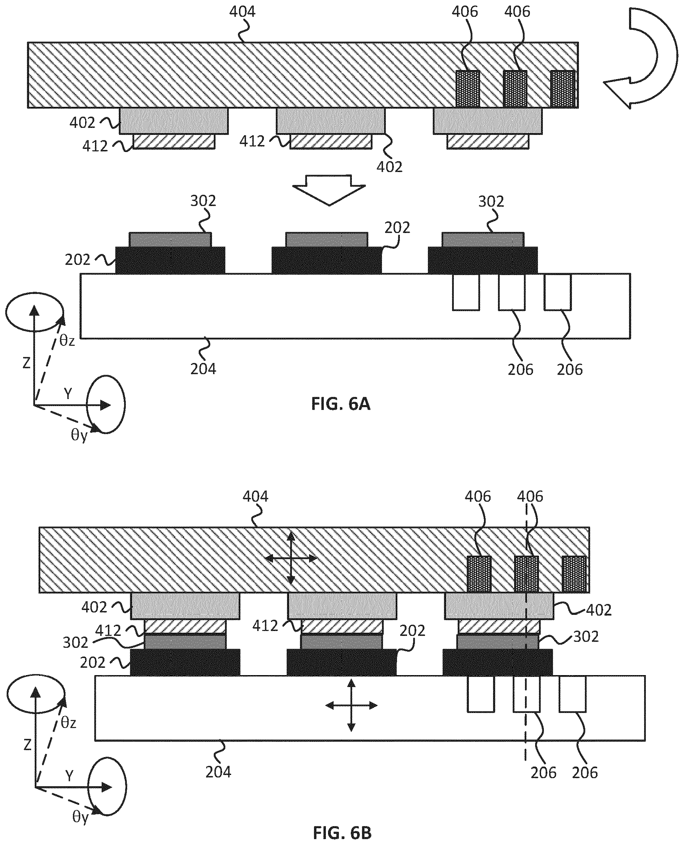

Figures 6A-6D are schematic diagrams illustrating steps of a method of placing a donor die on target locations. Figures 6A-6D are cross-sectional views of various steps of die placement. Figure 6A depicts placement of the donor dies 302 on the target dies 412, by bringing the support structure 204 and support structure 404 into proximity. In Figure 6A, the support structure 404 is shown as approaching the support structure 204, however the direction of approach is relative in the support structure 204 may instead or additionally approach the support structure 404. In Figure 6A, the support structure 404 is shown as being rotated (e.g., about the x-axis) in order to complement the position of the support structure 204, however either or both the support structure 204 and the support structure 404 may be rotated or translated before approach. The support structure 404 may be aligned (e.g., in the X direction, in the Y direction, in the Z direction, rotationally, etc.) with the support structure 204 based on alignment marks, for example based on the alignment marks 406 with the alignment marks 206.

Figure 6B depicts fine alignment of the support structure 404 and the support structure 204 as the donor dies 302 are contacted by the target dies 412. Adjustment of the support structure 404, the support structure 204, the die actuators 202, or the die actuators 402 may be used to provide fine alignment of the target die 412 in the donor die 302 as the target die 412 and the donor die 302 are contacted. The alignment of the donor die 302 and the target die 412 may be accurate to within 200 nm. The alignment of the donor die 302 and the target die 412 when supported by the die actuators 202 or the die actuators 402 may be more accurate than can be accomplished by pick and place alone. The placement of the donor die 302 on the target die 412 when supported by the die actuators 202 or the die actuators 402 may additionally (or instead) be faster than placement by a die bonder. The placement of the donor die 302 on the target die 412 when supported by the die actuators 202 or the die actuators 402 may provide die placement for various dies which are not whole wafers, e.g., for diced wafers which cannot be placed, aligned, or bonded by wafer bonders which may require that the donor die 302 and the target die 412 have the same dimensions (e.g., which may be most useful for homogeneous integration).

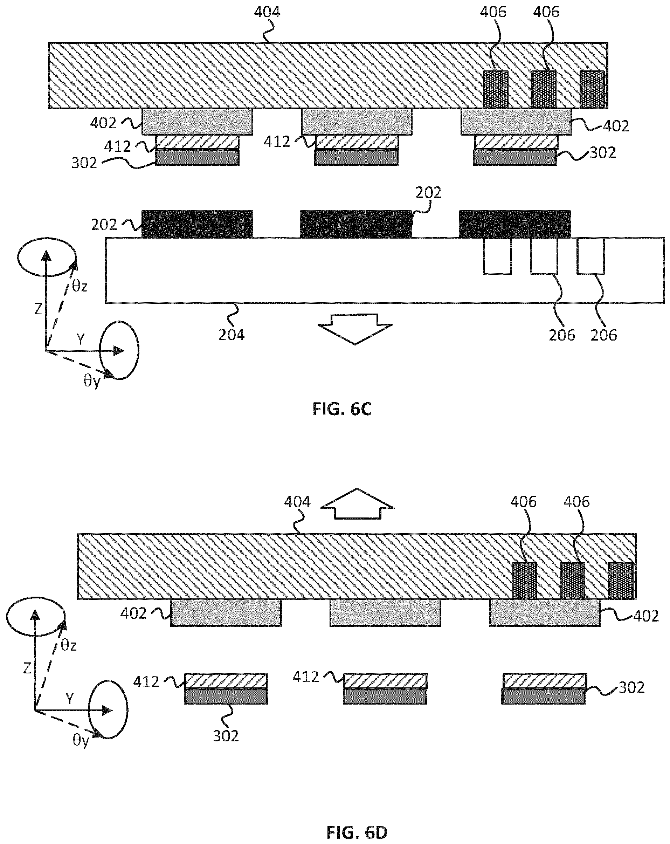

Figure 6C depicts removal of the support structure 204 after the donor dies 302 are contacted by the target dies 412. Contact of the donor dies 302 with the target dies 412 may include adhesion (e.g., electrostatic adhesion, van der Waals attraction, etc.) or annealing of the donor dies 302 the target dies 412. After the donor dies 302 are adhered to the target dies 412, the target dies 412 may be released, including electrostatically, from the die actuators 202. The release may include active disengagement, for example electrostatic repelling between the die actuators 202 and the donor dies 302. After the donor dies 302 are released from the die actuators 202, the support structure 204 may be moved to separate the die actuators 202 and the donor die 302. The removal of the support structure 204 is depicted along the Z direction but may be instead or additionally in another direction. In some embodiments the removal of the support structure 204 may include deconstruction or breaking apart of the support structure 204.

Figure 6D depicts removal of the support structure 404 after the donor dies 302 are adhered to the contact dies 412. The donor dies 302 in the contact dies 412 may be supported by another support structure (not depicted), for example a collection receptacle, a chip feeder line, etc. As described in reference to the release of the donor die 302 from the die actuators 202 and the support structure 204, the target die 412 may be actively or passively released from the die actuators 402 and the support structure 404. The donor die 302 and the contact die 412 may be annealed or otherwise electrically, physically, chemically, etc. joined before or after removal of the support structure 404 (or removal of the support structure 204). The donor die 302 and the target die 412, once joined, may function as a single unit, e.g., of circuitry. The donor die 302 and the target die 412 may be further processed, such as via lithography, may be further analyzed, such as via electrical testing, may be further diced, may be further integrated including with additional die (e.g., such as additional donor die 302, additional target die 412, additional die of a different type, etc.), may be packaged, etc.

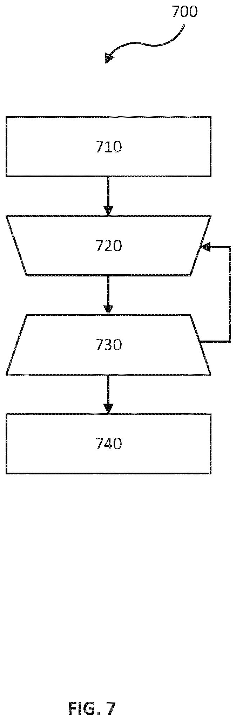

Figure 7 is a flowchart which illustrates a method of die alignment. Each of these operations is described in detail below. The operations of method 700 presented below are intended to be illustrative. In some embodiments, method 700 may be accomplished with one or more additional operations not described, and/or without one or more of the operations discussed. Additionally, the order in which the operations of method 700 are illustrated in Figure 7 and described below is not intended to be limiting. In some embodiments, one or more portions of method 700 may be implemented (e.g., by simulation, modeling, etc.) in one or more processing devices (e.g., one or more processors). The one or more processing devices may include one or more devices executing some or all of the operations of method 700 in response to instructions stored electronically on an electronic storage medium. The one or more processing devices may include one or more devices configured through hardware, firmware, and/or software to be specifically designed for execution of one or more of the operations of method 700, for example.

At an operation 710, a plurality of target locations are obtained. The target locations may correspond to locations of a plurality of target die. The target locations may correspond to a plurality of locations on a target wafer. The target locations may be positions (e.g., positions in three dimensions such as along X, Y, and Z axes, positions in six directions such as along X, Y, and Z axes and with respect to angles of rotation about those axes, etc.). The target locations may be sets of positions, for example 2 or more positions of or on targets (such as electrically active areas like electrically active areas 108 of Figure 1A) to which areas of the donor die are to be bonded.

The plurality of target locations may be obtained from target patterns, e.g., from plans of the target locations. The plurality of target locations may be obtained for measurement, for example from measurement of fabricated target dies, target wafers, etc. The plurality of target locations may be obtained in any appropriate coordinate system, such as relative to one or more alignment marks on a target wafer, on die actuators, on a support structure, etc.

In some embodiments, die actuators may be placed on a support structure based on the obtained plurality of target locations. That is, the plurality of target locations may be used to inform the pick and place element when placing the plurality of die actuators. In some embodiments donor die may be placed on the die actuators based on the obtained plurality of target locations. That is, the plurality of target locations may be used to inform the pick and place element when placing the plurality of donor die.

At an operation 720, a plurality of donor die locations are obtained. The donor die locations may be obtained via measurement of one or more positions of the donor dies along one or more dimension. The locations of the plurality of donor dies may be measured in-plane (e.g., in the x-y plane) via first method and measured out of plane (e.g., in the Z direction) via a second method. For example, the locations of the plurality of donor die may be measured based on one or more images in-plane. The locations of the plurality of donor die may be obtained from a two-dimensional image, which may show locations of the edges or corners of the donor die with respect to positions on a support structure or on die actuators. The locations of the plurality of donor die may be obtained based on features (for example electrically active areas) on an exposed surface of the donor die. These features of the donor die may be used as alignment marks or reference marks. In some embodiments, alignment marks may be included as exposed features of the donor die. The alignment marks may be specifically added for die bonding or may be alignment marks corresponding to previous fabrication steps.

At an operation 730, the locations of the plurality of donor die are adjusted. Adjusted includes cases in which locations are minimally or substantially not adjusted after measurement, such as if a measured location corresponds to the target location within a threshold. The locations of the plurality of donor die may be adjusted by action of the die actuators. The die actuator may adjust a length, position, angle of one or more support (e.g., a strut) which supports a donor die chuck or other donor die support. The die actuators may be controlled, including electrically controlled. By one or more measurement systems, such as a measurement system which incorporates a location measurement element. The die actuators may be controlled by a system, such as the one or more measurement systems, which also controls a pick and place element. Adjustment of the locations of the plurality of donor die may correspond to adjustment of one or more donor die check. Adjustment of the locations of the plurality of donor die may correspond to adjustment of locations of one or more donor die actuators.

Adjustment of the locations of the plurality of donor die may include iterative measurement of the plurality of donor die locations, including as adjustment occurs. In one or more embodiment, iterative measurement and adjustment steps may be used for a threshold number of iterations (for example, 1 iteration, 2 iterations, etc.). In one or more embodiment, iterative measurement and adjustment steps may be used until a threshold donor die placement is reached, such as a minimum offset from an intended position. In one or more embodiment, iterative adjustment may be triggered by a difference between donor die placement differing from donor die intended position by more than a threshold. For example, a plurality of donor die locations may be obtained, the locations of the plurality of donor die may be adjusted, and the plurality of adjusted donor die locations may be obtained. Based on a determination that the adjusted donor die locations conform to intended locations to within a threshold, iteration of measurement and adjustment may be exited. Based on a determination that the adjusted donor die location do not conform to intended locations to within a threshold, iteration of measurement and adjustment may be continued.

At an operation 740, the plurality of donor die are placed on the plurality of target locations. The donor die may be placed on the target locations by movement of one or more support structure or one or more die actuator. The donor die in the target locations may experience self-alignment as the donor die are brought into contact with the target locations. For example, the donor die may be biased with respect to the target locations such that electrically active areas of the donor die are attracted to certain areas, such as electrically attractive areas, of the target locations. The plurality of donor die may be adhered to the plurality of target locations. The plurality of donor die may be bonded, such as by annealing, to the plurality of target locations. The plurality of donor die may be released from the from the plurality of die actuators or from the support structure.

In some embodiments, an additional set of donor die may be placed on the plurality of die actuators. For example, if the target locations correspond to target locations for a target wafer, the target locations acquired for one of the target wafers may be applied to additional target wafers with the same manufacturing parameters. In another example, if multiple die are to be stacked, target locations for a second layer stacking may be acquired when the first layer stacking occurs-e.g., donor die locations for a first layer stacking may be used as target locations for a second layer stacking.

As described above, method 700 (and/or the other methods and systems described herein) is configured for alignment of multiple die.

Figures 8A-8B are a schematic diagrams illustrating an example die actuator. Figure 8A is a cross-sectional view of an example die actuator consisting of a main body 802, die actuator clamps 804, shear piezoelectric elements 808, a die platform 810, and a die clamp 812. Also depicted are a donor die 820 and a support structure 830. The main body 802 of the die actuator may contain one or more die actuator electrodes 840. The main body 802 may have dimensions in the x-y plane of approximately 10 mm by 10 mm. The main body 802 may be fabricated of metal, semiconductor material (such as silicon, silicon dioxide, etc.). The main body 802 may be fabricated by additive or subtractive fabrication. The main body 802 may be fabricated by three-dimensional printing. The side walls of the main body 802 may be taller than or shorter than the height of the die platform 810. The die actuator clamps 804 may be electrostatic clamps. The die actuator clamps 804 may be capacitive clamps. The die actuator clamps may contain shear piezoelectric material between two clamps (which may be electrostatic clamps, which may be capacitive clamps, etc.), where each of the clamps and the shear piezoelectric element may each be operated independently. The die actuator clamps 804 may apply a high voltage (which may be constant or a varying signal) to surfaces of the main body 802 of the die actuator, to surfaces of the shear piezoelectric elements 808, and to surfaces of the die platform 810 to induce attraction between the die actuator clamps 804 and surfaces of main body 802, the die platform 810, or the shear piezoelectric element 808. When engaged, the die actuator clamps 804 may prevent movement of the main body 802, the die platform 810, or the shear piezoelectric element 808 relative to one another (e.g., prevent sliding of the die platform 810 relative to the main body 802). When released, the die actuator clamps 804 may allow surfaces of the main body 802, the die platform 810, or the shear piezoelectric element 808 to slide past one another. The die actuator clamps 804 may operate to produce micro-stepper functionality between the shear piezoelectric element 808, the main body 802, and the die platform 810.

The support structure 830 may contain one or more controller electrodes 842, which may operate with the die actuator electrodes 840 to supply power to and control the die actuator. The one or more controller electrodes 842 may supply power to the die actuator electrodes, such as inductively, capacitively (e.g., through capacitive charging), etc. Although the one or more controller electrodes 842 and the one or more die actuator electrodes 840 are shown as separated by depth of the main body 802 and the support structure 830, it should be understood that the one or more controller electrodes may be surface electrodes and that the one or more die actuator electrodes may be surface electrodes. The one or more controller electrodes may supply power, actuation signals, control signals, etc. including by different of the one or more controller electrodes. The signals may be wireless, impedance based, capacitive, voltage based, current based, etc. For example, a given of the one or more controller 842 electrodes may supply power, while another of the one or more controller electrodes 842 may supply a control signal for a given die actuator clamp 804. The one or more die actuator electrodes 840 may also correspond to different elements of the die actuator. For example, a given of the one or more die actuator electrodes 840 may correspond to a clamping effect of a given of the die actuator clamps while another of the one or more die actuator electrodes 840 may correspond to a release effect for the given of the die actuator clamps. The die actuator electrodes 840 may be provided, by the one or more controller electrodes 842, with signals which cause actuation of the die actuator. For example, the die actuator electrodes 840 corresponding to the piezoelectric element 808 and the die actuator clamps 804 may be actuated (e.g., turned on or off) based in turn based on digital or analog signals from the one or more controller electrodes 842.

A relationship between the one or more controller electrodes 842 and the one or more die actuator electrodes 840 may be known (e.g., based on a measured placement of the die actuator main body 802 on the support structure 830) or may be determined, such as by providing a test signal to each of the one or more controller electrodes 842 in turn and observing (e.g., experimentally) corresponding effects on the die actuator, which may include clamping, releasing, piezoelectric action, etc.

The support structure 830 may be a wafer, for example, a silicon dioxide on silicon wafer, provided with patterned electrodes. The support structure may be a printed circuit board (PCB), including a ceramic PCB. The support structure 830 may be a wafer chuck, such as constructed of Teflon or another inert material, with embedded electrodes.

The die actuator may operate by adjusting the position of one or more support of the die clamp 812. The die clamps 812 may be an electrostatic clamp, which functions to clamp or release the donor die 820. The die clamps 812 may apply a high voltage (which may be constant or a varying signal) to a donor die 820 to induce electrostatic attraction between the die clamps 812 and the donor die 820 to provide adhesion of the donor die 820 to the die clamps 812. The die clamp 812 may be actuated by a voltage signal received at a die actuator electrode 842. The die platform 810 is depicted as being supported by at least two legs 816 (shown in the cross-sectional view), which are in turn supported by die actuator clamps 804 and a shear piezoelectric element 818. The position of the legs 816 supporting the die platform 810 may be adjusted through use of the shear piezoelectric elements 808, which may operate as a stepper in conjunction with two or more of the die actuator clamps 804. A stepper function, in which the two or more die actuator clamps 804 corresponding to a leg 816 supporting the die platform 810 alternatively grip and release may be used to eliminate hysteresis from movement of the die platform 810, where shear piezoelectric elements may be susceptible to hysteresis and drift. The legs 816 may be metal or other material able to withstand bending and forces consistent with the placement of the donor die 820 on the die platform 810 and placement of the donor die 820 on a target die (e.g., able to withstand pressure without breaking or able to spring back after deformation). Although two legs 816 are shown supporting the die platform 810, it should be understood that more legs 816 may be used, and that legs 816 may not be in plane with one another in the y-plane (as shown for ease of description only). The legs 816 may be further constructed to withstand forces from die placement, such as by incorporating a leafspring, other spring element, bent element, etc. The legs 816 may be formed by wire-electrical discharge machining (wire-EDM), by laser cutting, etc. The legs 816 may have an angle with respect to the base of the die platform (e.g., the foot) or with respect to the die platform (e.g., with respect to the donor die). The thickness of the leg 816 may be adjusted in order to adjust the stiffness of the die platform 810.

Figure 8B is a cross-sectional view of a portion of the example die actuator of Figure 8A. Figure 8B depicts a portion of the main body 802, the shear piezoelectric elements 808, and a portion of the die platform 810. Figure 8B also depicts three die actuator clamps 804A-804C which may operate together to form a microstepper to adjust positions of the die platform 810 by adjusting positions of the leg 816. The shear piezoelectric element 808 may be altered, such as by application of electric potential. The shear piezoelectric element 808 is shown as being able to bend along the y-direction, but this depiction is by way of example only and the shear piezoelectric element 808 may alter in other ways, such as in size (e.g., by extension of contraction), or along different direction. The shear piezoelectric element 808 may experience drift or hysteresis (such as may be a property of some types of piezoelectric materials). In order to mitigate these factors, the shear piezoelectric element 808 may be used together with an unmoving pillar or other portion of the main body 802 to operate as a stepper.

In stepper mode, the die actuator clamps 804A-804C may clamp and release in a cycle to adjust a position of a base of the leg 816 and therefore to adjust a position of the donor die (e.g., the donor die 820 of Figure 8A). For example, in order to move the leg 816 towards the positive y-direction, the die actuator clamp 804A may be released (e.g., receive a signal to release an electrostatic or other clamping, which may be a voltage drop from an on voltage to an off voltage) while the die actuators clamps 804A-804C remain clamped (e.g., receive a signal to remain clamps, which may be an on voltage signal or maintenance of the same). Once the die actuator clamp 804A is released, the shear piezoelectric element 808 may be activated (e.g., receive a voltage change signal, for example, switch from a large positive voltage to a large negative voltage) which may cause the shear piezoelectric element 808 to move from its initial position to an excited position, such as the position shown by the dotted parallelogram 850. The dotted parallelogram 850 is provided as an example only, and the excited position of the piezoelectric element 808 may be determined by the material and initial conformation of the shear piezoelectric element 808. The activation of the shear piezoelectric element 808 may consequently move the leg 816 (and the die platform 810) in the positive y-direction-as shown by dotted figure 852 (corresponding to a position of the die actuator clamp 804B) and dotted figure 854 (corresponding to a position of the die platform 810). While the shear piezoelectric element 808 remains tensed, the die actuator clamp 804A may be clamped (e.g., may receive a signal to initiate clamping, which may be a voltage switch from an off voltage to an on voltage), which may hold the leg 816 and the die platform 810 at the new position. Once the die actuator clamp 804A is clamped, the die actuator clamp 804B or 804C may be released (e.g., receive a signal to release clamping, which may be a voltage drop from an on voltage to an off voltage). This may allow the shear piezoelectric element 808 to be deactivated (e.g., de-energized, which may correspond to receiving a voltage change signal, for example returning to a near zero voltage or changing from a large negative voltage to a large positive voltage) and to return to an initial or relaxed confirmation. The piezoelectric element 808 may be energized and de-energized (or energized in one direction and then another instead of de-energized) in a cycle with clamping and releasing of the die actuator clamps 804A-804C in order to "step" or incrementally move the position of the leg 816, the die platform 810, and the donor die (e.g., the donor die 820 of Figure 8A).

Multiple piezoelectric elements (such as piezoelectric element 808) may be used to provide multi-directional adjustment of the leg 816, the die platform 810, and the donor die (e.g., the donor die 820 of Figure 8A). For example, an additional column (not shown) of one or more die actuator clamps and a shear piezoelectric element may be present which may move a base of the leg along the x-direction. In one embodiment, multiple shear piezoelectric elements may be used to move the leg 816 in multiple directions at once-such as by activating both the shear piezoelectric element 808 in the y-direction and also activating a shear piezoelectric element (not shown) in the x-direction-while the die actuator clamp 804A is disengaged. In one embodiment, shear piezoelectric elements may be used to move the leg 816 in multiple directions one at a time (e.g., sequentially).

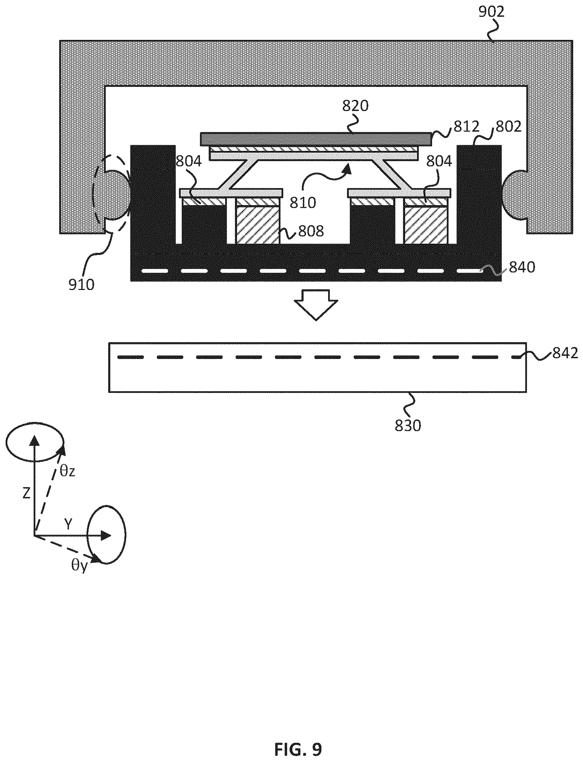

Figure 9 is a schematic diagram illustrating a relationship between an example pick and place system and an example die actuator. Figure 9 is a cross-sectional view of an example die actuator (e.g., the die actuator of Figure 8) being placed on the support structure (e.g., the support structure 830 of Figure 8). The die actuator may be moved by a pick and place element (for example, the pick and place element 216 of Figure 2A). The die actuator may be picked, carried, place, or otherwise manipulated by the pick and place element through a specialized end effector, such as end effector 902. The end effector 902 may be shaped to contact the main body (e.g., the main body 802 of Figure 8) of the die actuator. The end effector 902 may adhere or attract the main body of the die actuator electrostatically, through use of suction, via hydraulic effects, etc. The end effector 902 may have opening or closing elements (e.g., grabber arms or other sliding elements), which may be used to select or hold a die actuator. The end effector 902 may have dimensions similar to an outer dimension of the main body 810 of the die actuator. The main body 810 of the die actuator may have sidewalls which protrude in the z-direction to enable the end effector 902 to adhere to the die actuator.. The end effector 902 may have one or more release mechanism, in order to release the main body of the die actuator after is it places on the support structure. As depicted, the end effector 902 contains adhesion elements identified by dotted ellipse 910. The adhesion elements may be electrostatic, suction, capacitive, etc. adhesion elements. The adhesion elements may be any appropriate adhesion element, including those described in reference to the pick and place element 216 of Figure 2A. The adhesion elements are depicted as interacting with vertical planes of the main body 810 of the die actuator, but may instead interact with other planes or a single plane of the die actuator. For example, the die actuator may contain a horizontal plane or pedestal which the pick and place element interacts with by suction. In another example, the die actuator may contain vertical places surrounding the donor die 820 along both sides in the x-direction and both sides in the y-direction. In this example, the end effector 902 may contain sliding elements which grip each of the four surrounding planes, such as through van der Waals forces, with friction pads, etc. The sliding elements may release (e.g., expand outward) to release the die actuator.

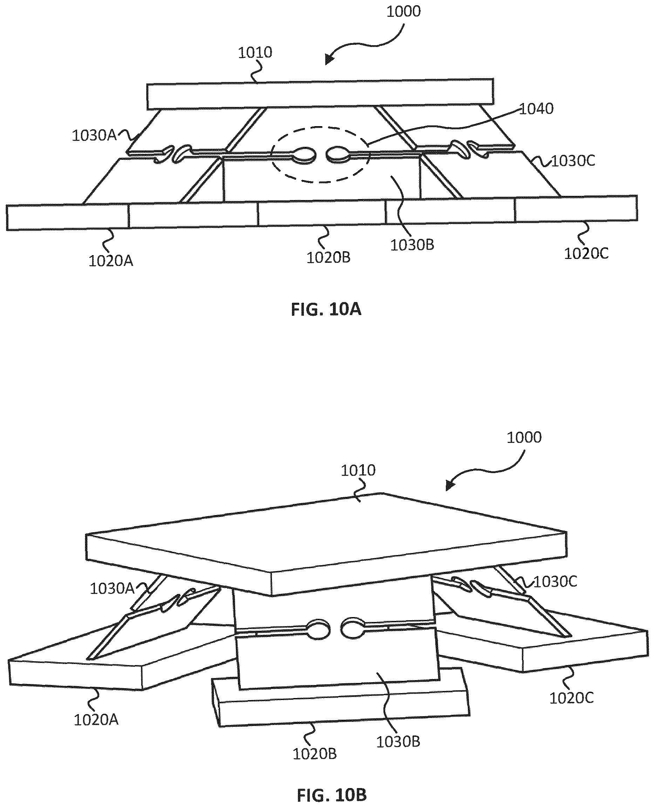

Figures 10A-10B are schematic diagrams illustrating an example die actuator. Figure 10A is a plan view of an example die actuator 1000, while Figure 10B is an orthogonal view of the example die actuator 1000. The example die actuator 1000 has a die platform 1010, which may further include a die clamp or other means of securing a donor die (or target die). The example die actuator 1000 has three supports (e.g., legs, structs, etc.) 1030A-1030C which support the die platform 1010. The three supports 1030A-1030C are notched leafsprings, which join the die platform at 45° angles (although other angles may be used). The notched leafsprings may be relatively planar with an example length of 3 mm and an example thickness of 0.1 mm. The notching of the leafspring (identified by dotted ellipse 1040 in the support 1030B) may be formed of voids cut into the planar surface of the leafspring. The notching of the leafspring may reduce stiffness of the leafspring. The width of the unnotched portion of the leafspring (e.g., the narrow region between the notched voids) may be adjusted to provide a desired stiffness. The notched leafsprings may have a preformed fold (e.g., a bend) such as in line with the notch. Each of the three supports 1030A-1030C is in turn supported by a foot (e.g., feet 1020A-1020B), which may be a point of contact with a support platform or which may rest on a main body of the die actuator. The three supports 1030A-1030C also join the feet 1020A-1020B at 45° angles (although other angles may be used). In the example die actuator 1000, three supports 1030A-1030C provide positioning adjustment to the die platform 1010 (and consequently to a donor die supported by the die platform 1010). Each of the three supports 1030A-1030C may be adjusted by movement of the corresponding foot 1020A-1020C. Each of the feet 1020A-1020C may be adjusted along the x-y plane in at least two orthogonal directions (e.g., along an x-direction and along a y-direction or along another two sets of axes rotated with respect to the x and y-axes). By moving each of the feet 1020A-1020C, the die platform 1010 may also be adjusted in the out of plane direction (e.g., along the z-direction). For example, the die platform 1010 may be raised in the z-direction by moving each of the feet 1020A-1020C inward and the die platform 1010 may be lowered by moving each of the feet 1020A-1020C outward. The three supports 1030A-1030C are depicted as leafsprings, but may instead or additionally be any other appropriate supports. The three supports 1030A-1030C which are depicted may be the minimum number of supports, such as required to adjust the position of the donor die with respect to six degrees of freedom. However, more supports may be used. Alternatively, if the donor die is only to be adjusted with respect to three degrees of freedom (for example, without accounting for rotation, of only in the x-y plane), fewer supports may be used. The die actuator 1000 may be constructed by machining, micromachining, etc. The die actuator 1000 may be constructed from a single material (for example, by destructive machining), from multiple materials (for example, by additive machining), or by a combination of similar and disparate materials.

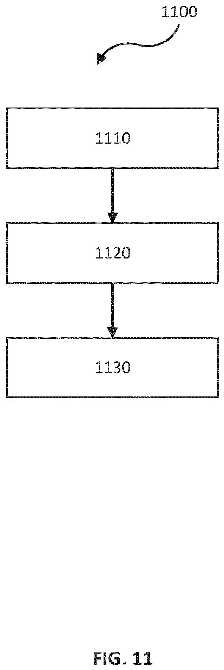

Figure 11 is a flowchart which illustrates a method of die actuator adjustment. Each of these operations is described in detail below. The operations of method 1100 presented below are intended to be illustrative. In some embodiments, method 1100 may be accomplished with one or more additional operations not described, and/or without one or more of the operations discussed. Additionally, the order in which the operations of method 1100 are illustrated in Figure 11 and described below is not intended to be limiting. In some embodiments, one or more portions of method 1100 may be implemented (e.g., by simulation, modeling, etc.) in one or more processing devices (e.g., one or more processors). The one or more processing devices may include one or more devices executing some or all of the operations of method 1100 in response to instructions stored electronically on an electronic storage medium. The one or more processing devices may include one or more devices configured through hardware, firmware, and/or software to be specifically designed for execution of one or more of the operations of method 1100, for example.

At an operation 1110, a donor die location is obtained. The donor die location may be obtained using any appropriate method, including those methods previously described in reference to the operation 720 of Figure 7. The donor die location may be measured or may be obtained from storage.

At an operation 1120, a target location corresponding to the donor die location is obtained. The target location may be obtained using any appropriate method, including those methods previously described in reference to the operation 710 of Figure 7. The target location may be measured or may be obtained from storage. The target location corresponding to a donor die may be identified from a plurality of target locations.

In some embodiments, the donor die location and the target location may be obtained in the opposite order-the order of operations provided herein are for illustration only and should not be taken as limiting. In some embodiments, an intended donor die location is determined based on the target location. For example, a corresponding location for the donor die (i.e., an intended donor die location) may be determined based on a difference between an ideal and actual target location. In some embodiments, a difference between the donor die location and the intended donor die location may be determined. The difference may be determined with respect to one or more direction, such as with respect to up to six degrees of freedom. The difference between the intended donor die location and the donor die location may be used to determine adjustment factors in as many as six degrees of freedom, where adjustment factors may be distances, angles of rotation, etc.

At an operation 1130, the location of donor die is adjusted. The locations of the donor dies may be adjusted by piezoelectric or other actuators. The locations of the donor dies may be adjusted by applying electrical actuation (or other actuation) to one or more support to lengthen or shorten the support. The location of the donor dies may be adjusted by applying electrical actuation to feet of one or more support (such as via a piezoelectric microstepper) to move the base of the one or more support in one or more direction at a time. The location of the donor die may be adjusted based on the donor die location, the target location, the relationship between the donor die location and the target location, etc. The location of the donor die may be adjusted using any appropriate method, such as those described in reference to Figures 7-10. In some embodiments, the location of the donor die may be measured (or otherwise obtained) after adjustment. The location of the donor die may be iteratively measured and adjusted. In some embodiments, the location of the donor die may be tracked as a function of adjustment, such as to determine drift of one or more adjustment actuators or to improve future adjustments.

As described above, method 1100 (and/or the other methods and systems described herein) is configured for positional adjustment of die.

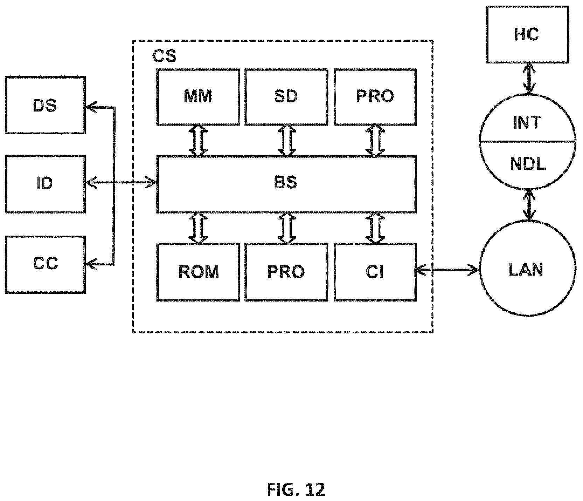

Figure 12 is a diagram of an example computer system CS that may be used for one or more of the operations described herein. Computer system CS includes a bus BS or other communication mechanism for communicating information, and a processor PRO (or multiple processors) coupled with bus BS for processing information. Computer system CS also includes a main memory MM, such as a random-access memory (RAM) or other dynamic storage device, coupled to bus BS for storing information and instructions to be executed by processor PRO. Main memory MM also may be used for storing temporary variables or other intermediate information during execution of instructions by processor PRO. Computer system CS further includes a read only memory (ROM) ROM or other static storage device coupled to bus BS for storing static information and instructions for processor PRO. A storage device SD, such as a magnetic disk or optical disk, is provided and coupled to bus BS for storing information and instructions.

Computer system CS may be coupled via bus BS to a display DS, such as a cathode ray tube (CRT) or flat panel or touch panel display for displaying information to a computer user. An input device ID, including alphanumeric and other keys, is coupled to bus BS for communicating information and command selections to processor PRO. Another type of user input device is cursor control CC, such as a mouse, a trackball, or cursor direction keys for communicating direction information and command selections to processor PRO and for controlling cursor movement on display DS. This input device typically has two degrees of freedom in two axes, a first axis (e.g., x) and a second axis (e.g., y), that allows the device to specify positions in a plane. A touch panel (screen) display may also be used as an input device.

In some embodiments, portions of one or more methods described herein may be performed by computer system CS in response to processor PRO executing one or more sequences of one or more instructions contained in main memory MM. Such instructions may be read into main memory MM from another computer-readable medium, such as storage device SD. Execution of the sequences of instructions included in main memory MM causes processor PRO to perform the process steps (operations) described herein. One or more processors in a multi-processing arrangement may also be employed to execute the sequences of instructions contained in main memory MM. In some embodiments, hard-wired circuitry may be used in place of or in combination with software instructions. Thus, the description herein is not limited to any specific combination of hardware circuitry and software.

The term "computer-readable medium" and/or "machine readable medium" as used herein refers to any medium that participates in providing instructions to processor PRO for execution. Such a medium may take many forms, including but not limited to, non-volatile media, volatile media, and transmission media. Non-volatile media include, for example, optical or magnetic disks, such as storage device SD. Volatile media include dynamic memory, such as main memory MM. Transmission media include coaxial cables, copper wire and fiber optics, including the wires that comprise bus BS. Transmission media can also take the form of acoustic or light waves, such as those generated during radio frequency (RF) and infrared (IR) data communications. Computer-readable media can be non-transitory, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge. Non-transitory computer readable media can have instructions recorded thereon. The instructions, when executed by a computer, can implement any of the operations described herein. Transitory computer-readable media can include a carrier wave or other propagating electromagnetic signal, for example.

Various forms of computer readable media may be involved in carrying one or more sequences of one or more instructions to processor PRO for execution. For example, the instructions may initially be borne on a magnetic disk of a remote computer. The remote computer can load the instructions into its dynamic memory and send the instructions over a telephone line using a modem. A modem local to computer system CS can receive the data on the telephone line and use an infrared transmitter to convert the data to an infrared signal. An infrared detector coupled to bus BS can receive the data carried in the infrared signal and place the data on bus BS. Bus BS carries the data to main memory MM, from which processor PRO retrieves and executes the instructions. The instructions received by main memory MM may optionally be stored on storage device SD either before or after execution by processor PRO.

Computer system CS may also include a communication interface CI coupled to bus BS. Communication interface CI provides a two-way data communication coupling to a network link NDL that is connected to a local network LAN. For example, communication interface CI may be an integrated services digital network (ISDN) card or a modem to provide a data communication connection to a corresponding type of telephone line. As another example, communication interface CI may be a local area network (LAN) card to provide a data communication connection to a compatible LAN. Wireless links may also be implemented. In any such implementation, communication interface CI sends and receives electrical, electromagnetic, or optical signals that carry digital data streams representing various types of information.

Network link NDL typically provides data communication through one or more networks to other data devices. For example, network link NDL may provide a connection through local network LAN to a host computer HC. This can include data communication services provided through the worldwide packet data communication network, now commonly referred to as the "Internet" INT. Local network LAN (Internet) may use electrical, electromagnetic, or optical signals that carry digital data streams. The signals through the various networks and the signals on network data link NDL and through communication interface CI, which carry the digital data to and from computer system CS, are exemplary forms of carrier waves transporting the information.

Computer system CS can send messages and receive data, including program code, through the network(s), network data link NDL, and communication interface CI. In the Internet example, host computer HC might transmit a requested code for an application program through Internet INT, network data link NDL, local network LAN, and communication interface CI. One such downloaded application may provide all or part of a method described herein, for example. The received code may be executed by processor PRO as it is received, and/or stored in storage device SD, or other non-volatile storage for later execution. In this manner, computer system CS may obtain application code in the form of a carrier wave.

Embodiments of the disclosure are defined in the following numbered clauses:
Clause 1: a method for die placement comprising:
   obtaining a plurality of target locations for a plurality of donor dies;
   measuring locations of the plurality of donor dies, the plurality of donor dies supported by a plurality of die actuators;
   adjusting the locations of the plurality of donor dies to substantially correspond to the plurality of target locations using the plurality of die actuators; and
   placing the plurality of donor dies on the plurality of target locations.
Clause 2: the method of clause 1, wherein measuring the locations of the plurality of donor dies comprises:
   placing the plurality of donor dies onto the plurality of die actuators, the plurality of die actuators supported by a support structure; and
   measuring the locations of the plurality of donor dies with respect to the support structure.
Clause 3: the method of clause 2, wherein measuring the locations of the plurality of donor dies further comprises:
   placing the plurality of die actuators on the support structure based on the plurality of target locations for the plurality of donor dies.
Clause 4: the method of clause 2, wherein placing the plurality of die actuators on the support structure comprise placing, using a pick and place tool, the plurality of die actuators on the support structure, the support structure configured to correspond substantially to the plurality of target locations.
Clause 5: the method of any one of clauses 2 to 4, wherein placing the plurality of donor dies further comprises:
   determining a value of a quality measure for multiple donor dies; and
   selecting the plurality of donor dies from the multiple donor dies for placement based on a determination that the value of the quality measure satisfies a threshold.
Clause 6: the method of clause 1, wherein adjusting the locations of the plurality of donor dies using the plurality of die actuators comprises:
   adjusting positions of the plurality of donor dies supported by donor die chucks of the plurality of die actuators by actuation of adjustable supports supporting the donor die chucks.
Clause 7: the method of clause 6, wherein the positions of the plurality of donor dies are adjustable with respect to six degrees of freedom.
Clause 8: the method of clause 1, wherein obtaining the plurality of target locations for the plurality of donor dies comprise obtaining the plurality of target locations for the plurality of donor dies in as many as six degrees of freedom, and wherein measuring the locations of the plurality of donor dies comprises measuring the locations of the plurality of donor dies in as many as six degrees of freedom. Clause 9: the method of clause 1, wherein obtaining the plurality of target locations for the plurality of donor dies comprises:
   measuring the plurality of target locations for the plurality of donor dies.
Clause 10: the method of clause 1, wherein adjusting the locations of the plurality of donor dies comprises:
   determining whether the locations of the plurality of donor dies correspond to the plurality of target locations; adjusting the locations of the plurality of donor dies by actuation of adjustable supports of the plurality of die actuators based on a determination that the locations of the plurality of donor do not correspond to the plurality of target locations.
Clause 11: the method of clause 1, wherein placing the plurality of donor dies on the plurality of target locations further comprises:
   disengaging the plurality of donor dies from the plurality of die actuators; and
   bonding the plurality of donor dies to the plurality of target locations.
Clause 12: the method of clause 11, further comprising:
   placing a second plurality of donor dies onto the plurality of die actuators;
   measuring locations of the second plurality of donor dies;
   adjusting the locations of the second plurality of donor dies to correspond substantially to the plurality of target locations using the plurality of die actuators; and
   placing the second plurality of donor dies on the plurality of target locations.
Clause 13: the method of clause 11, further comprising:
   obtaining a second plurality of target locations for a second plurality of donor dies;
   placing the second plurality of donor dies onto the plurality of die actuators;
   measuring locations of the second plurality of donor dies;
   adjusting the locations of the second plurality of donor dies to correspond substantially to the second plurality of target locations using the plurality of die actuators; and
   placing the second plurality of donor dies on the second plurality of target locations.
Clause 14: the method of clause 1, further comprising:
   annealing metal contacts of the plurality of donor dies to metal contacts on the plurality of target locations.
Clause 15: the method of clause 1, wherein the plurality of target locations comprise a plurality of target dies.
Clause 16: the method of clause 1, wherein measuring the locations of the plurality of donor dies comprises measuring locations of contacts on the plurality of donor dies.
Clause 17: the method of clause 16, wherein measuring the locations of the contacts comprises measuring locations of the contacts based on optical images.
Clause 18: the method of clause 16, wherein measuring locations of the contacts comprises measuring locations of the contacts based on confocal imaging.
Clause 19: a die actuator comprising:
   a donor die chuck; and
   at least three adjustable supports supporting the donor die chuck, a position of the donor die chuck being controllable by actuation of the adjustable supports.
Clause 20: the die actuator of clause 19, wherein the adjustable supports comprise piezoelectric steppers and wherein the position of the donor die chuck is controllable by electrical adjustment of the piezoelectric steppers.
Clause 21: the die actuator of clause 19, wherein the position of the donor die chuck is controllable in as many as six degrees of freedom.
Clause 22: the die actuator of clause 19, further comprising an electrostatic clamp, the donor die chuck being capable of holding a donor die via the electrostatic clamp.
Clause 23: the die actuator of clause 19, further comprising electrodes, the electrodes capable of receiving signals for actuation of elements the adjustable supports.
Clause 24: the die actuator of clause 23, wherein a first electrode is electrically connected to a piezoelectric element, the first electrode capable of receiving a signal corresponding to mechanical actuation of the piezoelectric element.
Clause 25: the die actuator of clause 23, wherein a second electrode is electrically connected to a clamping element, the second electrode capable of receiving a signal corresponding to engagement of the clamping element or release of the clamping element.
Clause 26: the die actuator of clause 23, wherein the signals for actuation of the elements of the adjustable supports are inductive signals.
Clause 27: the die actuator of clause 23, wherein the signals for actuation of the elements of the adjustable supports are capacitive signals.
Clause 28: a support structure comprising a plurality of the die actuators of clauses 19 to 27.
Clause 29: an apparatus comprising:
   a plurality of die actuators, wherein die actuators comprise, donor die chucks, each for supporting an associated donor die, a position of each donor die chuck controllable by actuation thereof; and
   a measurement system, functionally coupled to the plurality of die actuators, and configured to:
      obtain a plurality of target locations for a plurality of donor dies;
      obtain locations of the plurality of donor dies supported by the donor die chucks; and
      adjust the locations of the plurality of donor dies by actuation of the donor die chucks so that the locations of the plurality of donor dies correspond substantially to the plurality of target locations.
Clause 30: the apparatus of clause 29, wherein the die actuators further comprise at least three adjustable supports supporting each donor die chuck, the position of each donor die chuck controllable by actuation of the supporting adjustable supports.
Clause 31: the apparatus of clause 30, wherein the measurement system comprises a processor configured to adjust the locations of the plurality of donor dies by actuation of the supporting adjustable supports so that the locations of the plurality of donor dies correspond substantially to the plurality of target locations.
Clause 32: the apparatus of clause 29, wherein the measurement system comprises a processor configured to adjust the locations of the plurality of donor dies by actuation of the die actuators so that the locations of the plurality of donor dies correspond substantially to the plurality of target locations, the measurement system further comprising a camera configured to obtain optical images of the plurality of donor dies,
   wherein the locations of the plurality of donor dies are determined based on the optical images of the plurality of donor dies.
Clause 33: the apparatus of clause 32, the measurement system further comprising a second camera, configured to obtain optical images of the plurality of target locations,
   wherein the plurality of target locations determined based on the optical images of the plurality of target locations.
Clause 34: the apparatus of clause 29, wherein the measurement system comprises a processor configured to adjust the locations of the plurality of donor dies by actuation of the donor die chucks so that the locations of the plurality of donor dies correspond substantially to the plurality of target locations, the measurement system further comprising a confocal microscope, configured to obtain topography of the plurality of donor dies,
   wherein the locations of the plurality of donor dies are determined based on the topography of the plurality of donor dies.
Clause 35: the apparatus of clause 34, the measurement system further comprising a second confocal microscope, configured to obtain topography of the plurality of target locations,
   wherein the plurality of target locations is determined based on the topography of the plurality of target locations.
Clause 36: the apparatus of clause 29, further comprising:
   a pick and place tool, functionally coupled to the measurement system,
   the apparatus comprising a processor; and
   one or more non-transitory, machine-readable medium having instructions thereon, the instructions when executed by the processor being configured to:
      control the pick and place tool to place the plurality of donor dies on the plurality of die actuators.
Clause 37: the apparatus of clause 36, the instructions when executed by the processor further being configured to control the pick and place tool to place the plurality of die actuators on a support structure.
Clause 38: the apparatus of clause 29, further comprising:
   an alignment tool, functionally coupled to the measurement system, configured to align a structure supporting the plurality of die actuators with a structure supporting the plurality of target locations.
Clause 39: the apparatus of clause 29, further comprising:
   a wafer moving tool, functionally coupled to the measurement system, configured to:
   position at least one of a structure supporting the plurality of die actuators and a structure supporting the plurality of target locations; and
   contact the plurality of donor dies to the plurality of target locations by movement of at least one of the structure supporting the plurality of die actuators and the structure supporting the plurality of target locations by the wafer moving tool.
Clause 40: the apparatus of clause 29, further comprising:
   a bonding tool configured to bond the plurality of donor dies to the plurality of target locations

While the concepts disclosed herein may be used for manufacturing with a substrate such as a silicon wafer, it shall be understood that the disclosed concepts may be used with any type of manufacturing system (e.g., those used for manufacturing on substrates other than silicon wafers).

In addition, the combination and sub-combinations of disclosed elements may comprise separate embodiments. For example, one or more of the operations described above may be included in separate embodiments, or they may be included together in the same embodiment.

The descriptions above are intended to be illustrative, not limiting. Thus, it will be apparent to one skilled in the art that modifications may be made as described without departing from the scope of the claims set out below.

## Claims

1. An apparatus comprising:
a plurality of die actuators, wherein die actuators comprise, donor die chucks, each for supporting an associated donor die, a position of each donor die chuck controllable by actuation thereof; and
a measurement system, functionally coupled to the plurality of die actuators, and configured to:
obtain a plurality of target locations for a plurality of donor dies;
obtain locations of the plurality of donor dies supported by the donor die chucks; and
adjust the locations of the plurality of donor dies by actuation of the donor die chucks so that the locations of the plurality of donor dies correspond substantially to the plurality of target locations.

2. The apparatus of claim 1, wherein the die actuators further comprise at least three adjustable supports supporting each donor die chuck, the position of each donor die chuck controllable by actuation of the supporting adjustable supports.

3. The apparatus of claim 2, wherein the measurement system comprises a processor configured to adjust the locations of the plurality of donor dies by actuation of the supporting adjustable supports so that the locations of the plurality of donor dies correspond substantially to the plurality of target locations.

4. The apparatus of claim 1, wherein the measurement system comprises a processor configured to adjust the locations of the plurality of donor dies by actuation of the die actuators so that the locations of the plurality of donor dies correspond substantially to the plurality of target locations, the measurement system further comprising a camera configured to obtain optical images of the plurality of donor dies,
wherein the locations of the plurality of donor dies are determined based on the optical images of the plurality of donor dies.

5. The apparatus of claim 4, the measurement system further comprising a second camera, configured to obtain optical images of the plurality of target locations,
wherein the plurality of target locations determined based on the optical images of the plurality of target locations.

6. The apparatus of claim 1, wherein the measurement system comprises a processor configured to adjust the locations of the plurality of donor dies by actuation of the donor die chucks so that the locations of the plurality of donor dies correspond substantially to the plurality of target locations, the measurement system further comprising a confocal microscope, configured to obtain topography of the plurality of donor dies,
wherein the locations of the plurality of donor dies are determined based on the topography of the plurality of donor dies.

7. The apparatus of claim 6, the measurement system further comprising a second confocal microscope, configured to obtain topography of the plurality of target locations,
wherein the plurality of target locations is determined based on the topography of the plurality of target locations.

8. The apparatus of claim 1, further comprising:
a pick and place tool, functionally coupled to the measurement system,
the apparatus comprising a processor; and
one or more non-transitory, machine-readable medium having instructions thereon, the instructions when executed by the processor being configured to:
control the pick and place tool to place the plurality of donor dies on the plurality of die actuators.

9. The apparatus of claim 8, the instructions when executed by the processor further being configured to control the pick and place tool to place the plurality of die actuators on a support structure.

10. The apparatus of claim 1, further comprising:
an alignment tool, functionally coupled to the measurement system, configured to align a structure supporting the plurality of die actuators with a structure supporting the plurality of target locations.

11. The apparatus of claim 1, further comprising:
a wafer moving tool, functionally coupled to the measurement system, configured to:
position at least one of a structure supporting the plurality of die actuators and a structure supporting the plurality of target locations; and
contact the plurality of donor dies to the plurality of target locations by movement of at least one of the structure supporting the plurality of die actuators and the structure supporting the plurality of target locations by the wafer moving tool.

12. The apparatus of claim 1, further comprising:
a bonding tool configured to bond the plurality of donor dies to the plurality of target locations.

13. A method for die placement comprising:
obtaining a plurality of target locations for a plurality of donor dies;
measuring locations of the plurality of donor dies, the plurality of donor dies supported by a plurality of die actuators;
adjusting the locations of the plurality of donor dies to substantially correspond to the plurality of target locations using the plurality of die actuators; and
placing the plurality of donor dies on the plurality of target locations.

14. The method of claim 13, wherein measuring the locations of the plurality of donor dies comprises:
placing the plurality of donor dies onto the plurality of die actuators, the plurality of die actuators supported by a support structure; and
measuring the locations of the plurality of donor dies with respect to the support structure.

15. The method of claim 14, wherein measuring the locations of the plurality of donor dies further comprises:
placing the plurality of die actuators on the support structure based on the plurality of target locations for the plurality of donor dies.
